Europäisches Patentamt

European Patent Office

Office européen des brevets

(11) Publication number: **0 244 926**

**A2**

(12) **EUROPEAN PATENT APPLICATION**

(21) Application number: **87300897.3**

(22) Date of filing: **02.02.87**

(51) Int. Cl.⁴: **G06F 11/30**

(30) Priority: **09.05.86 US 861190**

(43) Date of publication of application:
**11.11.87 Bulletin 87/46**

(84) Designated Contracting States:
**DE FR GB NL**

(71) Applicant: **TEKTRONIX, INC.**
**Tektronix Industrial Park D/S Y3-121 4900**
**S.W. Griffith Drive P.O. Box 500**
**Beaverton Oregon 97077(US)**

(72) Inventor: **Teitzel, Robin L.**
**9385 N.W. Murlea Lane**
**Portland Oregon 97229(US)**

(74) Representative: **Wombwell, Francis**
**Potts, Kerr & Co. 15, Hamilton Square**
**Birkenhead Merseyside L41 6BR(GB)**

(54) **Register and stack monitoring logic analyzer.**

(57) A logic analyzer stores and decodes data appearing on a bus to deduce the instructions executed by a computer processor connected to the bus and to determine the value of data placed on the bus as the processor executes the instructions. From the instructions and data conveyed on the bus, the logic analyzer deduced changes to the contents of internal registers within the processor and to the contents of data stacks maintained in a memory by the processor. The logic analyzer stores the deduced instruction, register and stack information in a data base file, displays operator selected portions of the instruction, register and stack information on a screen and searches the data base file to identify and display particular instructions which caused operator specified changes to the contents of any of these registers or data stacks.

FIG.2

# REGISTER AND STACK MONITORING LOGIC ANALYZER

## Background of the Invention

The present invention relates in general to logic analyzers and in particular to a method and apparatus for monitoring the contents of internal registers within an operating computer processor and for monitoring the contents of data stacks maintained in a random access memory accessed by the computer processor.

Computer programmers often spend more time debugging programs than writing them. Programmers typically debug a program by running it on computer system and observing how the system responds. Any deviation of the observed system response from an expected response indicates a programming error and a programmer can sometimes deduce the error from the nature of the deviation. However it is not always easy to locate an error in complex software based on the observable response of the computer system, particularly when the software is written in assembly language, since hundreds of assembly language instructions may be executed in order to accomplish a single change in a display or other easily observable output of the computer system.

Many assembly language instructions cause a microprocessor to read or store data in an internal register, or push data onto or retrieve data from a stack (usually a portion of a random access memory (RAM) accessed by the microprocessor). Assembly language programmers therefore tend to view the operation of a microprocessor in response to instructions as a succession of microprocessor system state changes where the "state" of the microprocessor system is defined in terms of the contents of its internal registers and of the stacks it maintains. When a programmer writes each step of a program, the immediate objective of that step is often to effect some change to the contents of one or more registers or stacks. Therefore to debug a program it would be most helpful if the programmer could monitor how the contents of the internal registers and the stacks change as the microprocessor executes each instruction in a program.

Unfortunately there is no direct way to read the contents of internal registers within a microprocessor since the terminals of such registers are not physically accessible to monitoring equipment. The contents of an internal register may be read indirectly by instructing the microprocessor to place them on its external bus but this would require the insertion of extra instructions into a program being debugged. Such an "intrusive" method of monitoring register contents is difficult to set up and often causes additional program errors.

The data, address and control lines of a RAM used by the microprocessor to maintain a stack are physically accessible and therefore the contents of a stack can be read directly but such a direct approach to monitoring a stack would nonetheless requre changes to the hardware and/or software of the microprocessor system under test in order to avoid RAM access conflicts between the sytem under test and the monitoring equipment.

What is needed and would be useful is a method and apparatus for monitoring the contents of data stacks and internal registers accessed by a computer running a program wherein such system requires no changes in the program and no changes in the computer hardware.

## Summary of the Invention

In accordance with one aspect of the invention, a logic analyzer utilizes a probe to access data appearing sequentially on the data, address and control lines of a microprocessor bus while the microprocessor executes a sequence of instructions and the logic analyzer stores this sequence of data in a random access acquisition memory. The logic analyzer includes software enabling it to ascertain the sequence of instructions executed by the microprocessor from the stored sequence of data and to display the instructions on a cathode ray tube screen in the form of a scrollable list of representative instruction mnemonics. The logic analyzer software also deduces from this sequence of instructions a sequence of changes to the contents of registers within the microprocessor, and changes to the contents of data stacks maintained in a random access memory (RAM) by the microprocessor during execution of the instructions. When an operator selects one of the displayed instruction mnemonics with a cursor, the logic analyzer displays the deduced contents of the internal registers or the stacks as they appeared following microprocessor execution of the selected instruction. By selecting the displayed instruction mnemonics in succession, the operator may easily observe how the contents of the registers and stacks changed as the microcomputer executed each instruction. This method of monitoring the contents of registers and stacks requires no changes to the program being run on the microprocessor and no changes to computer hardware other than attachment of the probe to the bus.

Logic analyzers of the prior art have been adapted to monitor the data appearing on the external bus terminals of a computer processor as it executes a sequence of instructions and some of these logic analyzers include provisions for disassembling this data to determine the instructions transmitted to the computer. However logic analyzers of the prior art do not provide any indication of the effect that the instructions have on the contents of registers or stacks accessed by the microprocessor.

In accordance with another aspect of the invention, the logic analyzer includes search routines for locating within the deduced sequence of instructions executed by the microprocessor a specific instruction which caused the microprocessor to store operator specified data in a register or a stack. This aspect of the invention enables an operator to quickly determine, for instance, which instruction caused a particular value to appear in a particular register or which instruction pushed a particular data value onto a stack.

In accordance with a further aspect of the invention, the logic analyzer is adapted to display only operator specified types of instructions while suppressing the display of others. This aspect of the invention enables an operator, for instance to specify that only instructions which call or return from subroutines are displayed. The operator may then select each of these displayed instructions in succession in order to view the changes to the registers or stacks on a subroutine-by-subroutine basis.

It is accordingly an object of the invention to provide a method and apparatus for monitoring changes to the contents of registers within a microprocessor executing a sequence of instructions.

It is another object of the invention to provide a method and apparatus for monitoring changes to the contents of data stacks maintained by a microprocessor executing a sequence of instructions.

The subject matter of the present invention is particularly pointed out and distinctly claimed in the concluding portion of this specification. However, both the organization and method of operation, together with further advantages and objects thereof, may best be understood by reference to the following description taken in connection with accompanying drawings wherein like reference characters refer to like elements.

Drawings

FIG. 1 is a diagram illustrating the registers in a Motorola MC68000 microprocessor;

FIG. 2 is a block diagram of the hardware of a logic analyzer according to the present invention;

FIGS. 3-7 are illustrations of displays produced by the logic analyzer of the present invention;

FIGS. 8, 9A-C, 10A-C, and 11A-B are illustrations of command windows utilized by the logic analyzer of the present invention; and

FIGS. 12-18 are signal flow diagrams of software utilized by the logic analyzer of the present invention.

Detailed Description

A typical microprocessor executes binary microcode instructions stored in an addressable instruction memory, the instructions being transmitted to external terminals of the microprocessor through a bus interconnecting the memory and the microprocessor. While a programmer may initially write instructions in, for instance, assembly language, the instructions must be encoded into binary microcode (machine language) form and stored in the instruction memory before the microprocessor can carry out the instructions. Many instructions cause a microprocessor to write data into or read data out of an internal register within the microprocessor or to push data onto or retrieve data from a system or user stack. A "system stack" usually comprises a section of a random access memory (RAM) reserved for storing a sequence of instruction memory addresses, each indicating the storage location of the first instruction to be executed after completing a subroutine, trap routine or interrupt routine. A "user stack" is also a reserved portion of RAM for temporarily storing data generated by a program.

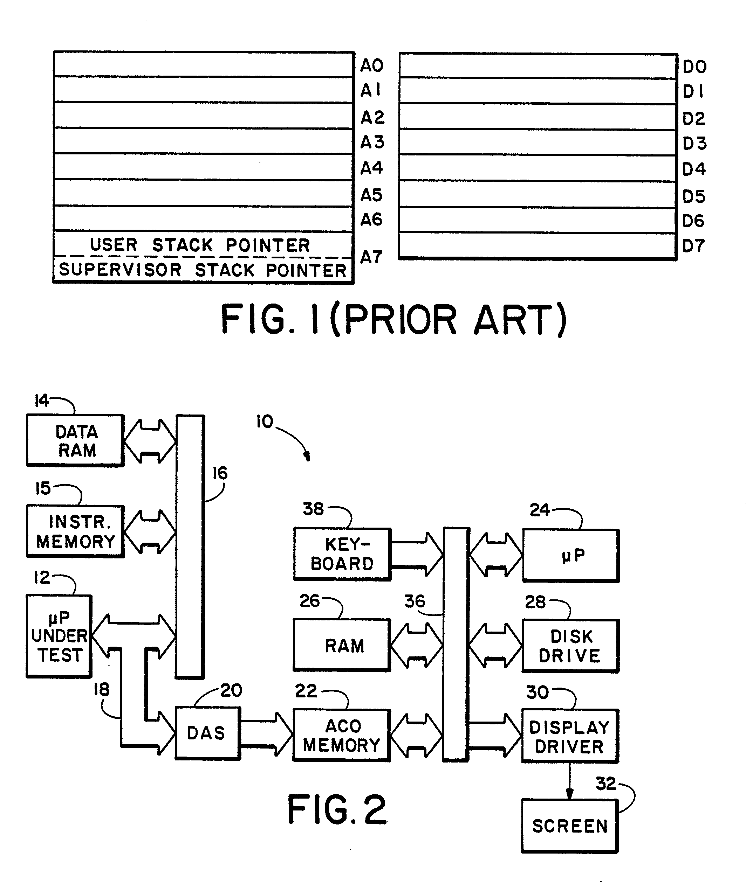

The Motorola model MC68000 microprocessor has a number of internal registers, illustrated in FIG. 1, including eight "data" registers (labeled D0-D7) and eight "address" registers (A0-A7), including one "stack" pointer register (A7). As an example of an operation which the microprocessor can perform on the contents of registers, the assembly language instruction "ADD D0,D6" tells the microprocessor to add the contents of register D0 to the contents of register D6 and to store the result in register D6. The instruction "ADD D0,(A3)" tells the microprocessor to add the contents of register D0 to data stored at a particular RAM address and to store the result at that RAM address, the RAM address being specified by the contents of address register A3. Instructions are normally executed in the address order that they are stored in the instruction memory except when an instruction tells the microprocessor to branch, jump or return to a memory location not in sequence. The instruction "JSR A5" tells the microprocessor to jump to the instruction memory address contained in address register A5 and to begin executing a subroutine comprising a set of instructions starting at that address. The JSR instruction also causes the microprocessor to store in the system stack the instruction memory address of the instruction immediately following the JSR instruction. The last instruction in the subroutine called by the JSR instruction is typically an "RTS" instruction which tells the microprocessor to begin executing instructions starting with the instruction stored at the last address pushed onto the system stack. The RTS instruction therefore tells the microprocessor to read and remove the last address from the system stack. The current RAM address of the last data pushed onto the system stack is maintained in the stack pointer register A7 and the value of stack pointer data stored in this register is incremented or decremented whenever data is pushed onto or pulled off of the system stack while the microprocessor is operating in a "system mode", i.e., when it is executing an instruction which alters the system stack. Stack pointer register A7 is actually a dual register, containing pointers for both the system and user stacks. The user stack pointer is changed when the microprocessor accesses the user stack while operating in a "user mode". The choice of user or system mode depends on the instruction being executed.

Assembly language programmers tend to view the operation of a microprocessor executing a set of assembly language instructions as a succession of changes to the contents of the internal registers and to the contents of the system and user stacks utilized by the microprocessor in the course of executing the instructions. When the programmer writes an instruction of an assembly language program, the immediate objective of that instruction is often to effect some desired change to the contents of a register or a stack and when the microprocessor executes the instruction any deviation of the contents of a register or a stack from the programmer's expectation would normally indicate that the instruction was improperly written.

Referring to FIG. 2, a logic analyzer 10 according to the present invention, depicted in block diagram form, is adapted to monitor the contents of the internal registers within a microprocessor 12 under test and of data stacks maintained by the microprocessor in a random access data memory 14 in the course of executing a sequence of microcode instructions stored in an instruction memory 15. Microprocessor 12 accesses memories 14 and 15 through a bus 16 comprising a set of data, address and control lines and the logic analyzer 10 accesses the lines in bus 16 through a probe 18 inserted between the microprocessor 12 and a socket which normally connects the microprocessor to the bus. The probe 18 includes sockets, pins and wiring to directly interconnect the pins of the microprocessor 12 to the bus and to a conventional data acquisition system (DAS) 20 portion of logic analyzer 10. As the microprocessor 12 executes a set of instructions stored in memory 15, a sequence of data appears on bus 16. At the same time this data is carried by probe 18 to DAS 20 which stores the data at sequentially incremented addresses in an acquisition memory 22. The logic analyzer 10 also includes a microprocessor 24, a random access memory (RAM) 26, a disk drive 28, and a display driver 30 for controlling a display on a cathode ray tube screen 32. The microprocessor 24 accesses RAM 26, drive 28, driver 30 and acquisition memory 22 through a bus 36. Operator input to the logic analyzer 10 is provided through a keyboard 38 connected to bus 36.

The microcode instructions stored in memory 15 are transmitted to the microprocessor under test 12 over bus 16, one instruction at a time. In the course of executing these instructions, microprocessor 12 may change the contents of its internal registers and may read or write data to RAM 14 via bus 16. Each time the microprocessor 12 sends or receives data over bus 16, DAS 20 stores in acquisition memory 22 data indicating the states of signals appearing on bus 16. When the microprocessor 12 has executed a set of instructions stored in RAM 15, and DAS 20 has stored the resulting sequence of data appearing on bus 16 in acquisition memory 22, microprocessor 24 of the logic analyzer 10, controlled by a program stored in RAM 26, reads the acquired bus data in memory 22 and decodes this data to ascertain the sequence of instructions sent to the microprocessor 12. The logic analyzer also deduces the changes to the contents of internal registers in microprocessor 12 and to the contents of memory stacks maintained by microprocessor 12 in the course of performing these instructions. The logic analyzer 10 stores the register, stack and memory change information on a disk in disk drive 28 and also displays this information on screen 32.

In order for the microprocessor 12 to execute an instruction, it first "fetches" the instruction from memory 15 during an instruction "fetch cycle" of bus 16, placing on the address lines of bus 16 the memory 15 address at which the instruction is stored and transmitting a read control signal to memory 15 over one of the control lines of bus 16. In response to the address and the read control signal, memory 15 places the stored code for the instruction on the data lines of the bus 16. Microprocessor 12 then reads and executes the instruction. The DAS 20 stores in memory 22 data indicating the states of the control, address and data lines appearing on bus 16 during the instruction fetch cycle. From this stored fetch cycle data, the logic analyzer 10 determines the memory address of RAM 14, the operation performed (an instruction memory read), and the instruction sent to the microprocessor 12. Assuming for instance that the fetched instruction is "MOVE (A4), D3", commanding the microprocessor 12 to move data stored in a RAM 14 address indicated by the contents of register A4 into register D3, then the next bus cycle will be a "read cycle" wherein the microprocessor 12 places the contents of address register A4 on the address lines of bus 16 and generates a read control signal on bus 16, causing memory 14 to transmit the data at that address to the microprocessor 12 over the data lines of bus 16. The microprocessor then stores the data in register D3. In the meantime, the logic analyzer 10 acquires the address, data and control data occurring on bus 16 during the bus 16 memory read cycle and stores the data in memory 22. From the data acquired thus far, the logic analyzer 10 can deduce the magnitude of the data stored in internal register D3 of microprocessor 12. Assuming that the next instruction fetched from memory 14 is "Move D3, D0", indicating that the microprocessor is to store the contents of register D3 in register D0, this instruction is performed by the microprocessor 12 without accessing memory 14. Therefore microprocessor 12 places no data on the address of data lines of bus 16 when it executes the instruction. However, knowing that the microprocessor 12 acquired and executed this particular instruction, and knowing the contents of register D3, the logic analyzer 10 can deduce the contents of register D0.

Generally speaking, the contents of internal registers of interest within a microprocessor 12 at any time of interest can be deduced by monitoring data acquired from an external RAM, ROM or other data source through bus 16 and stored in these registers, and by keeping track of subsequent transfers of data between registers and of operations performed on register contents by the microprocessor 12 in response to instructions transmitted over the bus. Of course, prior to acquisition of any bus data, the logic analyzer 10 cannot deduce the contents of any of the internal registers, and it is only after the microprocessor 12 executes an instruction moving data between an internal register and bus 16 that the logic analyzer 10 can deduce the content of any particular internal register. And it is only after execution of many instructions resulting in the storage of data in various internal registers that the contents of any appreciable number of internal registers can be deduced. However in practice, if the data acquired by DAS 20 and stored in memory 20 includes all of the instructions in the program being executed by the microprocessor 12, or at least includes a few hundred instructions preceding some point of interest in a program executed by the microprocessor, then the contents of any internal register of interest to a programmer monitoring the state of the processor at that point can usually be deduced by the logic analyzer 10 of the present invention.

The contents of a stack maintained by microprocessor 12 in the course of executing a set of instructions are ascertained by decoding instructions which affect the contents of the stack or which affect the magnitude of a stack pointer stored in a stack pointer register, and by monitoring the data pushed onto the stack as the data is transmitted over bus 16 to memory 14.

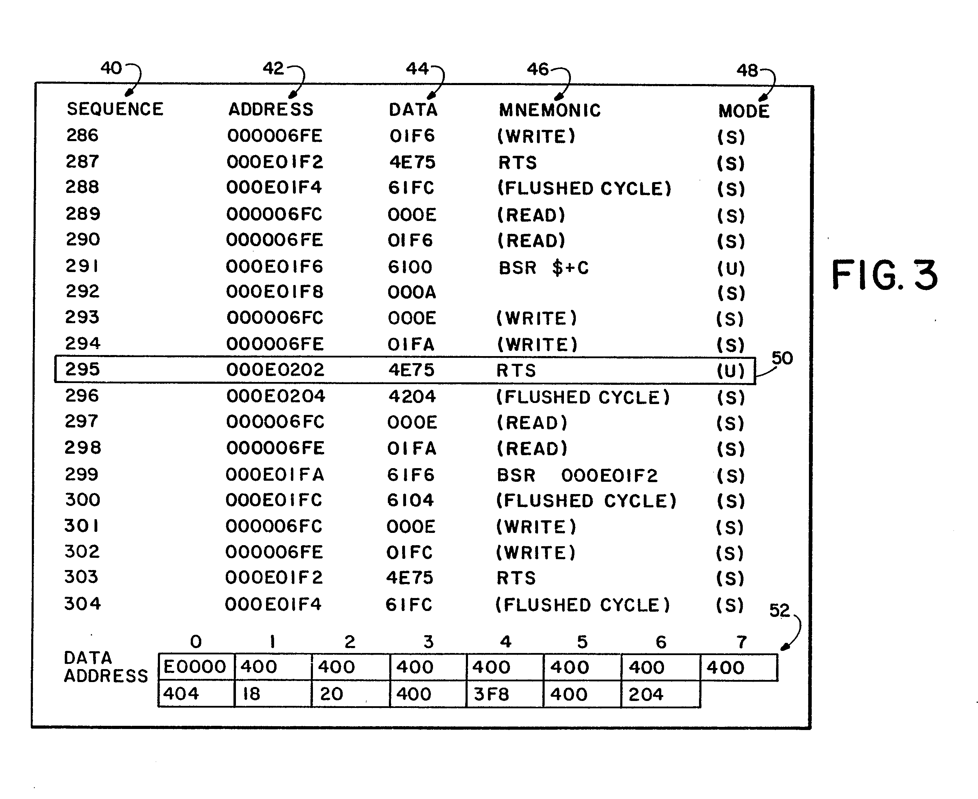

FIG. 3 is an illustration of a typical display produced by logic analyzer 10 on screen 32 after the logic analyzer has acquired and disassembled a sequence of bus cycle data appearing on bus 16 while a microprocessor 12 under test executed a sequence of instructions. Each cycle of the bus 16 is represented by a separate bus cycle data line on the display of FIG. 3. Each bus cycle data line starts with a "sequence number" (in column 40), the sequence number being a decimal representation of the acquisition memory 22 address at which the bus cycle data is stored. The next data in each line (column 42) is a hexadecimal representation of the data appearing on the address lines of bus 16, followed in column 44 by a hexadecimal representation of the data appearing on the data lines of bus 16 during the bus cycle. If the bus cycle was an instruction fetch cycle, a mnemonic is displayed in a column 46 indicating the assembly language representation of the instruction transmitted during the fetch cycle. If the bus cycle was a memory write or read cycle, an interrupt cycle, or a "flushed" cycle, then a (WRITE), (READ), (INTERRUPT) or a (FLUSHED CYCLE) mnemonic is displayed in column 46. A (FLUSHED CYCLE) mnemonic indicates that an instruction was conveyed to the microprocessor under test but was not executed. The Motorola MC68000 actually fetches and stores each instruction before it has carried out the last fetched instruction. When the last fetched instruction is a jump, branch, return or similar instruction, telling the microprocessor to fetch and execute an instruction from an out of sequence instruction memory address, the microprocessor must ignore (or "flush") the instruction it has just fetched without executing it. The logic analyzer of the present invention determines from the last executed instruction whether or not the microprocessor flushed the next fetched instruction. If so, the logic analyzer displays the (FLUSHED CYCLE) mnemonic in column 46 instead of the instruction mnemonic.

Every line in the display of FIG. 3 representing bus cycle data also includes a (U) or (S) mnemonic in a column 48 indicating whether the microprocessor was operating in the user or a supervisory mode as determined from the state of one of the control lines on bus 16. In the Motorola MC68000 microprocessor, certain instructions may be executed only when the microprocessor is in the supervisory mode and the microprocessor must be placed in the appropriate user or supervisor mode in order to access the user and supervisory stacks.

Thus by inspection of the display of FIG. 3, a user can determine, for example, that the data stored at acquisition memory address 295 was obtained during an instruction fetch cycle and that the instruction fetched was an RTS (return from subroutine) instruction. The user can also see that the data on the address bus during the bus cycle was 000E0202, that the data on the data bus was 4E75 (the microcode for the RTS instruction), and that the microprocessor was operating in the user mode.

The logic analyzer of the present invention permits an operator to utilize control keys on the keyboard 38 of FIG. 2 to scroll the lines of bus cycle information on the screen to show data associated with lower or higher sequence numbers, thereby enabling the operator to view any section of bus cycle data within a long sequence of bus cycle data stored in the acquisition memory. The logic analyzer also permits a user to move a highlighting cursor 50 up and down on the display of FIG. 3 to highlight any selected line of bus cycle data. A set of boxes 52, labeled DATA 0 -DATA 7 and ADDRESS 0 - ADDRESS 6, are displayed in the lower portion of the screen and each box contains data representing the deduced contents of a corresponding internal register in microprocessor 12 or FIG. 2 as they appeared immediately following the bus cycle highlighted by cursor 50. In the instant example of FIG. 3, the content of address register A1 has a value of 18 (hexadecimal) immediately after execution of the RTS instruction of bus cycle sequence number 295. When the operator moves the cursor 50 up or down, or when the operator scrolls the bus cycle data display without moving the cursor, the data in a box 52 changes whenever cursor 50 highlights a bus cycle line associated with an instruction which changed the contents of one of the internal registers in microprocessor 12 of FIG. 2. Thus by scrolling the bus cycle lines upward, or moving cursor 50 down, an operator can observe the sequence of changes to the contents of the internal registers D0-D7 and A0-A6 in response to the sequence of instructions performed by the microprocessor under test.

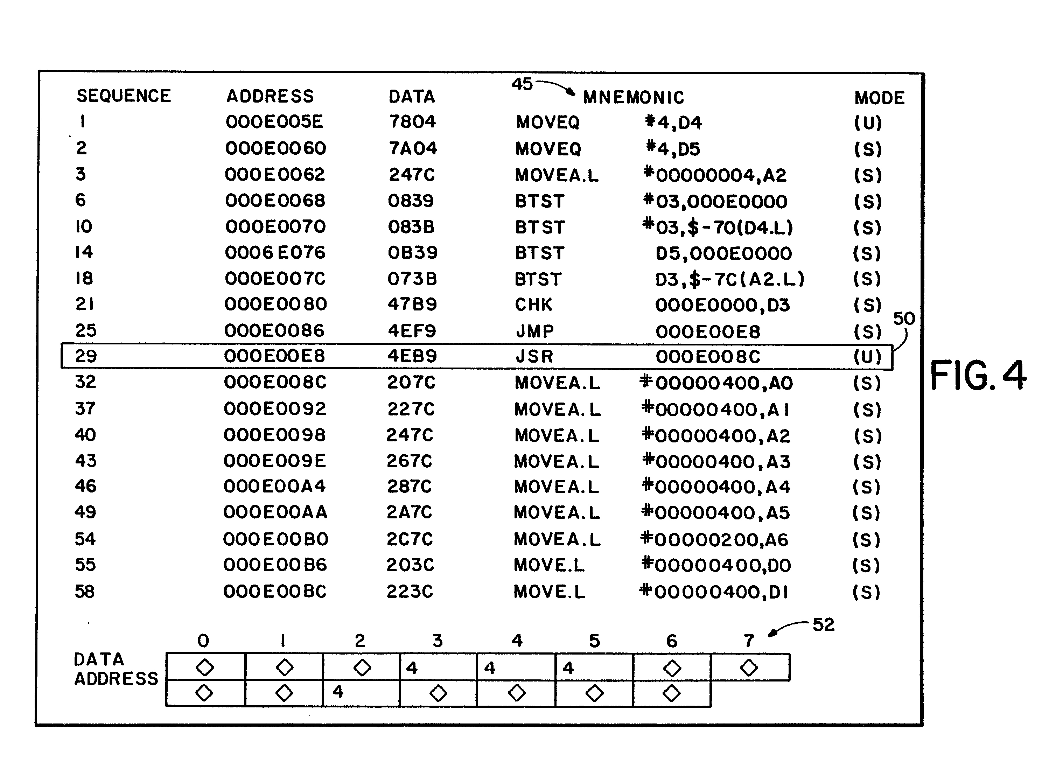

The display of FIG. 3 is produced when the logic analyzer is operating in a "hardware display" mode wherein every bus cycle data line is displayed on the screen. FIG. 4 illustrates a "software display" mode where only bus cycle data lines associated with instruction fetch bus cycles are displayed, the display of the intervening read, write, interrupt and flushed cycle data lines being suppressed. This provides a more compact representation of microprocessor operation and allows the operator to monitor changes to internal registers on an instruction-by-instruction basis. It is noted that the display of FIG. 4 includes sequence number 1, indicating the first bus cycle data acquired by logic analyzer. The logic analyzer cannot deduce the contents of the internal registers prior to execution of any instructions and when the contents of a register is unknown, the corresponding box 52 of FIG. 4 contains a diamond symbol. After the logic analyzer has enough information to deduce the contents of a register, the diamond symbol is replaced with data. In FIG. 4, boxes 52 indicate the known contents of the internal registers immediately following bus cycle sequence number 29. The logic analyzer has deduced that data registers D3-5 and address register A2 each contain the number 4 but cannot ascertain the contents of the other registers from the instructions preceding bus sequence number 29.

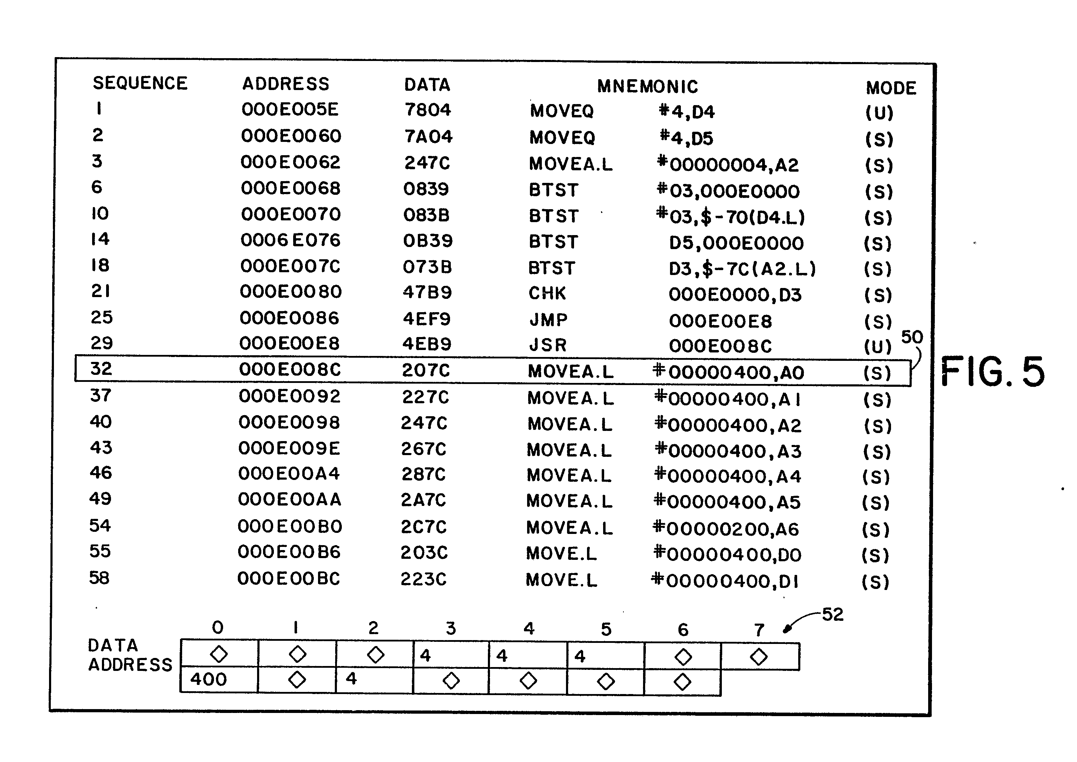

The display of FIG. 5 is similar to that of FIG. 4 except that the operator has moved the highlighting cursor 50 from the sequence number 29 line in FIG. 4 to the sequence number 32 line in FIG. 5. The instruction associated with sequence number 32 is a "MOVEA.L #00000400,A0" instruction which caused the microprocessor to load the value 400 into internal register A0. Thus in the A0 box 52 of FIG 5, the diamond symbol has been replaced with the number 400.

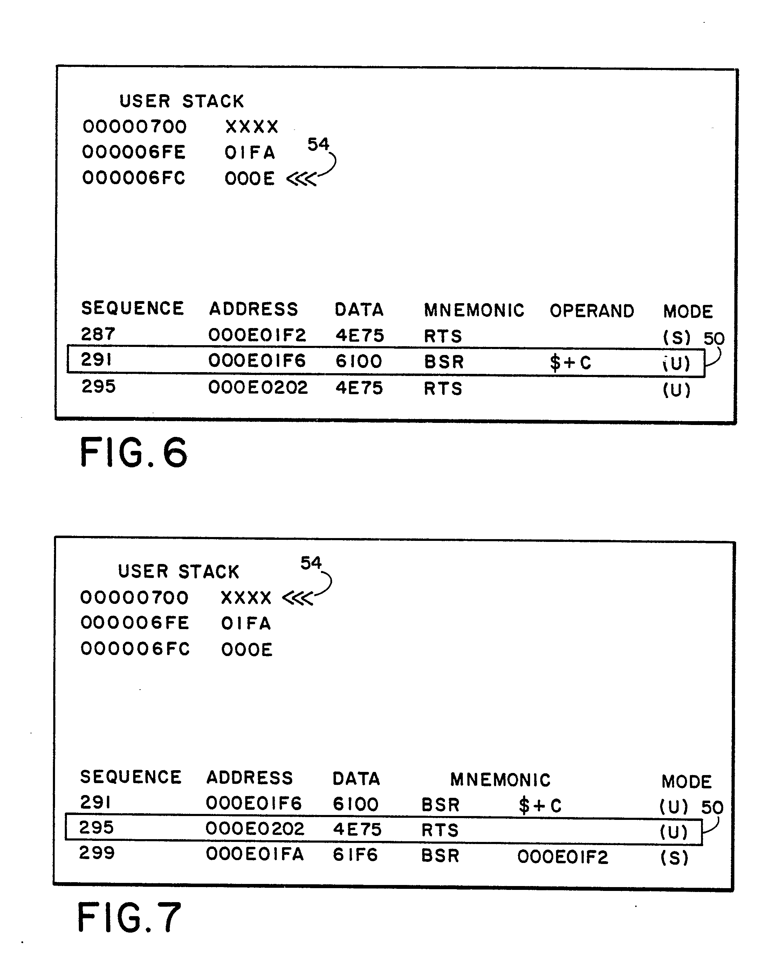

FIG. 6 illustrates a typical display produced by the logic analyzer of the present invention to indicate the contents of a user stack maintained by the microprocessor under test. In the present example, the last data stored in the user stack (000E) is at memory addresses 000006FC and 000006FD and is indicated by a stack point symbol 54. The next most recently stored data in the stack (01FA) appears at memory addresses 000006FE and 000006FF. As seen from the display of FIG.6, data which may have been pushed onto the stack prior to 01FA is stored at memory locations 00000700 and above but has unknown value as indicated by an XXXX symbol. The memory address indicated by the user stack pointer is maintained in an internal register of the microprocessor under test (register A7 in the case of a Motorola MC68000 microprocessor). Three lines of bus cycle data are included at the bottom of the display of FIG. 6 with the center line being highlighted by cursor 50. The contents of the user stack are shown in the display of FIG. 6 as they existed following bus cycle sequence number 291 highlighted by the cursor.

An operator may view changes to the user stack as the microprocessor executed a sequence of instructions by utilizing a logic analyzer keyboard key to scroll bus cycle data lines upward or downward. A display illustrated in FIG. 7 is similar to the display of FIG. 6 except that the operator has scrolled the bus cycle data upward by one line so that the line starting with sequence number 295 is highlighted. The instruction fetched during this bus cycle was a return to subroutine (RTS) executed while the microprocessor was in a user mode. This instruction caused the microprocessor to pull from the user stack the address (000E01FA) of the next instruction to be fetched. Since the address requires two words, both of the last two words on the user stack are required. In the display of FIG. 7 the stack pointer symbol 54 is moved up to indicate that the 000E and 01FA data words have been pulled from the stack in response to the RTS instruction. The two data words pulled from the stack continued to be displayed because they still remain at these memory locations until written over when additional data is pushed onto the stack.

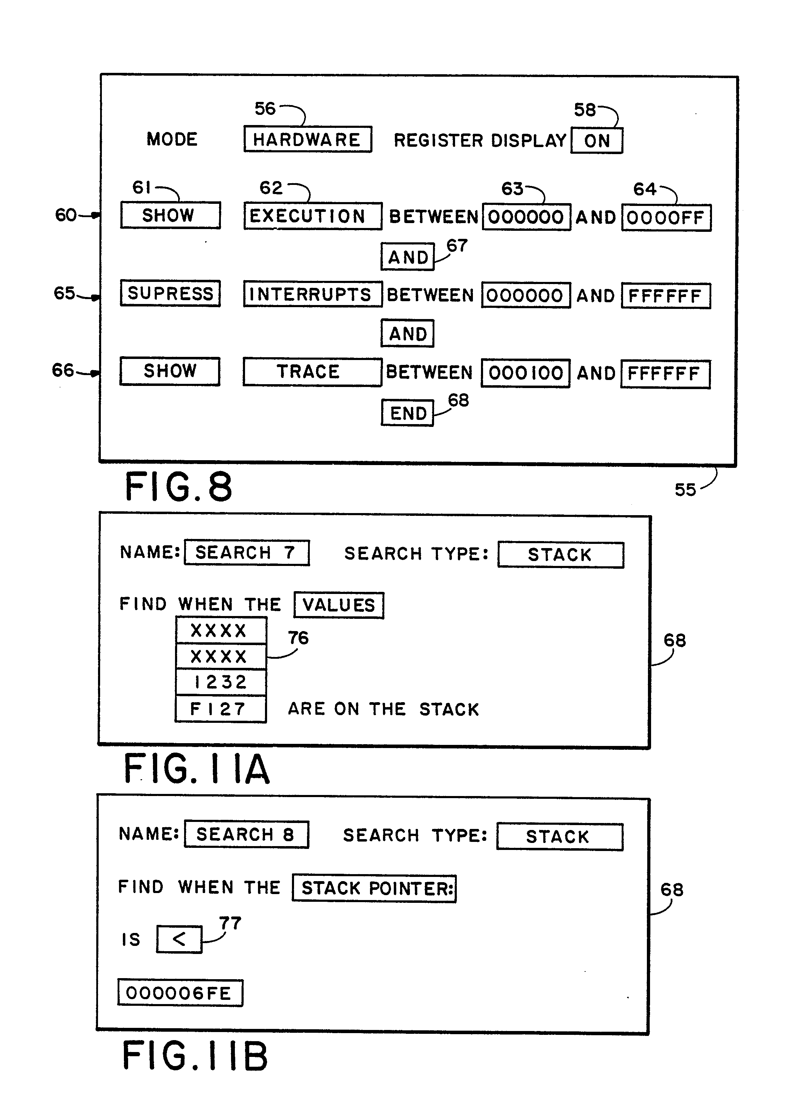

The user can specify a display format indicating which types of bus cycle data lines are to be displayed and which types of bus cycle data lines are to be suppressed in a display such as depicted in FIG. 4. To specify a display format, the operator presses a function key on the keyboard 38 of FIG. 2 which causes the logic analyzer to display a formatting command window on screen 32. FIG. 8 illustrates an example of a display format command window 55. The format command window 55 includes a box 56 which displays the current display mode (HARDWARE or SOFTWARE) and the operator can toggle between hardware and software display modes by selecting window 56 with a cursor and depressing a key on the keyboard. The operator can also select whether the register data boxes are to be displayed by positioning the cursor over a "REGISTER DISPLAY" box 58 and depressing a key to toggle the register display "ON" or "OFF".

The display format window 55 permits the operator to define which types of bus cycle data are to be displayed and which types are to be suppressed by providing input data for a set of up to eight display command lines. Four such command lines (60, 65, 70 and 75) are utilized in the example of FIG. 8. The first box of each·display command line permits the operator to select from among the words "SHOW" or "SUPPRESS". The second box permits the operator to select from among the words "EXECUTION", "INTERRUPTS", and "TRACE", and the third and fourth boxes of each line permit the operator to type in sequence numbers. In the example of FIG. 8 the operator has selected "SHOW" for the first box, and "EXECUTION" for the second box of line 60, and has typed in the sequence numbers 000000 and 0000FF in the third and fourth boxes 63 and 64 of line 60. This line 60 tells the logic analyzer that it is to display in the hardware mode all bus cycle data starting with sequence number 000000 and ending with sequence number 0000FF.

After line 60, a box 67 is displayed which permits the operator to select from among the words "AND" and "END", and in this example the operatorhas selected the word "AND" to indicate more instructions follow.

In the next line 65, the operator has indicated that the logic analyzer should suppress the display of all bus cycle data associated with interrupt routines occurring between sequence numbers 000000 and FFFFFF. In another line 66, the operator has selected the "TRACE" command which indicates that for sequence numbers from 000100 to FFFFFF, the logic analyzer is to display only bus cycle data lines associated with jump, branch, return and similar instructions which cause a break in the sequence of instruction execution. The operator has selected the "END" command in a last box 68 to indicate to the logic analyzer that line 66 was the last command line of display format instruction. Thus, based on the display format window 55 selections made by the operator, the logic analyzer suppresses or displays various combinations of bus cycle data based on sequence number and bus cycle type. This feature permits suppression of the display of bus cycle data of no interest to the operator to provide a more compact display of more important bus cycle data. The "TRACE" option in particular permits the operator to view bus cycle data associated only with instructions which enter and return from subroutines or cause program branches, thereby enabling the operator to view the effects of a program on register or stack contents on a subroutine-by-subroutine basis rather than by a bus-cycle-by-bus-cycle or instruction-by-instruction basis.

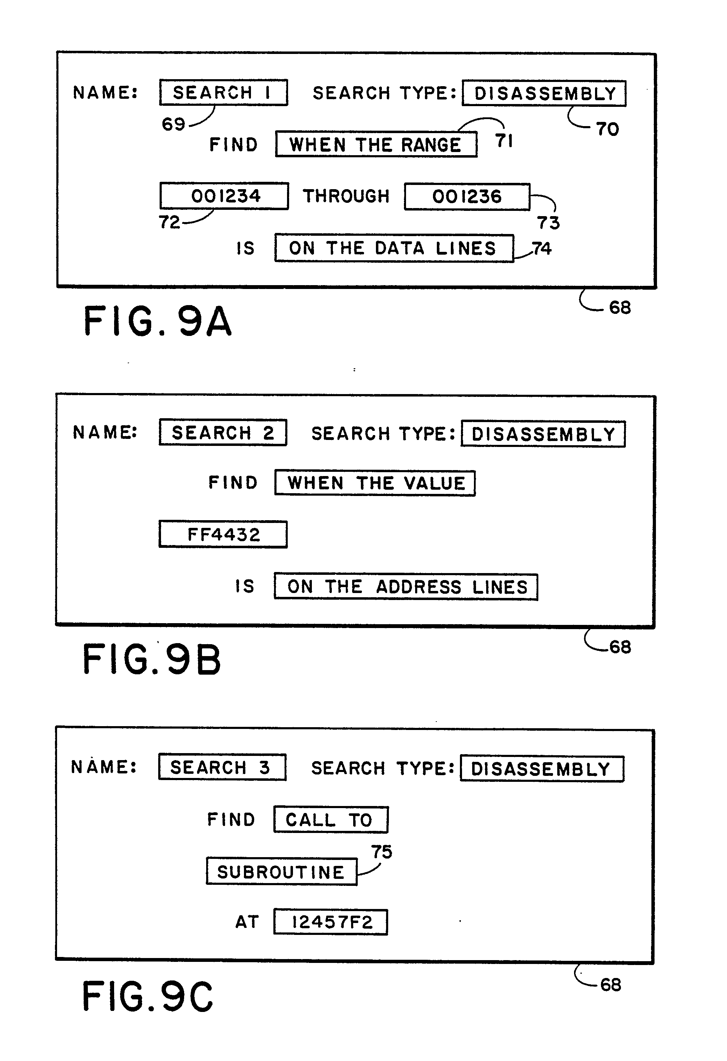

The logic analyzer of the present invention includes search routines for scrolling the bus cycle data display until it displays a particular bus cycle data line according to various search selection parameters provided by an operator. The search routines help the operator to more quickly locate a particular instruction which caused the microprocessor to respond in some particular way, for instance to load a register with a specified value or to place a particular value on the address or data lines of the bus. To specify the basis of a particular search, the operator depresses a function key on the keyboard to request the logic analyzer to display, on top of a bus cycle data display, a search format window 68 as illustrated in FIGS. 9A-9C. The operator selects desired search parameters by modifying the contents of parameter boxes displayed in the search format window 68 and then depresses a function key to initiate the search according to the specified parameters. The logic analyzer then removes the window from the display and scrolls the displayed bus cycle data lines upward on the screen until the first bus cycle data line satisfying the specified search parameters is displayed.

Referring to FIG. 9A, the search format window 68 includes boxes which indicate operator defined search format parameters which indicate the basis of a particular search. The operator types in a name (such as "SEARCH 1") for the search in a first box 69 in window 68 and if this name was previously used to identify a search, the logic analyzer automatically fills all of the other boxes in window 68 with the search format parameters previously defined for the search of the same name. If the search name provided by the operator is new, the logic analyzer fills all of the boxes in window 68 with default values. A second box 70 in window 68 permits the operator to define a search type by selecting from among the words "DISASSEMBLY", "REGISTER" or "STACK". In a "DISASSEMBLY" type search, the logic analyzer looks for the next bus cycle during which the data or address lines carried data having values or ranges of values specified by the operator or in which an instruction called a subroutine starting at an operator specified instruction memory address. FIG. 9A illustrates a search format window 68 defining a disassembly search wherein the logic analyzer is to display the next line of bus cycle data wherein a value within the range of 001234 to 001236 is placed on the data bus. The operator toggled a box 71, by pointing to the box with a cursor and depressing a keyboard key, to select a phrase from among "WHEN IN THE RANGE", "WHEN THE VALUE" and "CALL TO" to be displayed in box 71. In FIG. 9A the operator has selected "WHEN IN THE RANGE" to indicate that the logic analyzer is to look for a range of bus values. This caused the logic analyzer to display two more boxes 72 and 73, separated by the word "THROUGH", and thereafter the operator typed the values 001234 and 0001236 into the boxes 72 and 73 to indicate the range of values that the logic analyzer is to search for. The logic analyzer also displays the word "IS" followed by another box 74 when the phrase "WHEN IN THE RANGE" is selected in box 71, and the operator can toggle the box with cursor and key to select either the phrase "ON THE DATA LINES" or "ON THE ADDRESS LINES" to indicate whether the logic analyzer is to search for data values conveyed on the address or data lines.

FIG. 9B illustrates a search format window 68 specifying a disassembly type search wherein the logic analyzer is to scroll up to the next bus cycle data line indicating that the value FF4432 is on the address line. FIG. 9C is another example of a disassembly type search format window 68 defining a search wherein the logic analyzer is to locate and display the next bus cycle data line which calls a subroutine starting at instruction memory address 12457F2. The box 75 of window 68 can also be toggled to display the phrase "ANY SUBROUTINE" instead of the word "SUBROUTINE" such that the logic analyzer will search for the next instruction which causes the microprocessor to jump or branch to any memory address.

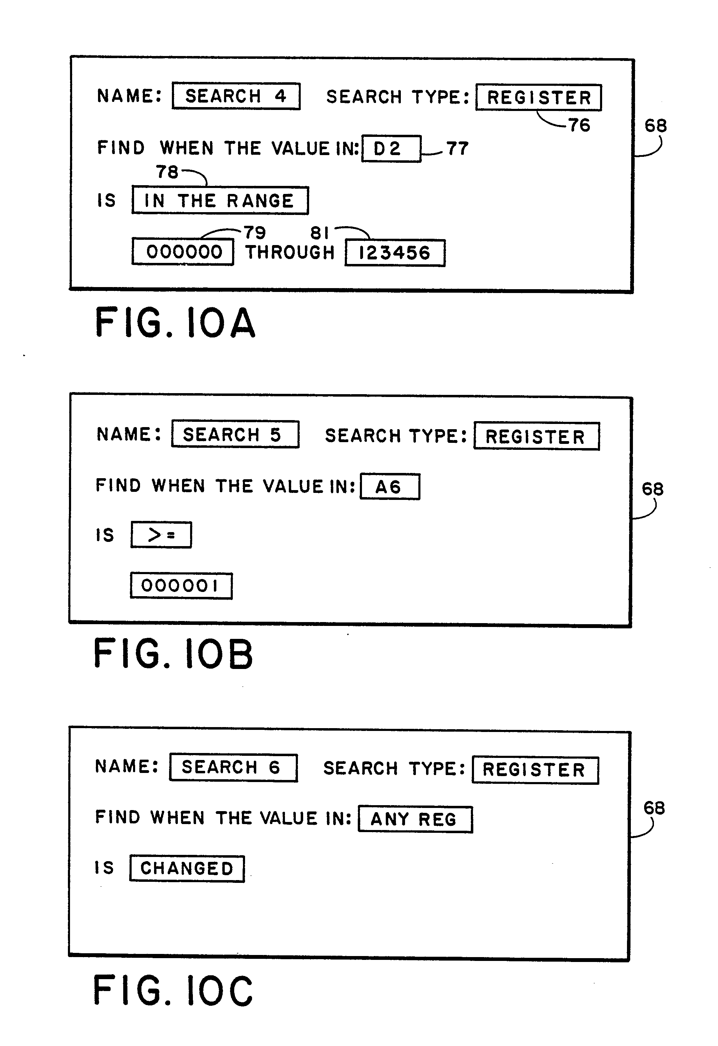

FIGS. 10A-10C illustrate search format windows 68 defining three different register type searches. FIG. 10A illustrates a search format telling the logic analyzer to search for the next instruction causing a particular data register (register D2) to store a value between 000000 and 123456. Referring to FIG. 10A, when the operator selects the register type search by toggling box 76, the logic analyzer plays the words "FIND WHEN THE VALUE IN:" followed by a box 77 in which the the operator may toggle in an address register designation (A0-A7), a data register designation (D0-D7) or the words "ANY REGISTER". In the present example the operator has selected register D2. The logic analyzer also disdisplays the word "IS" followed by a box 78. Box 78, also toggled with a keyboard key when selected by a cursor, can display either the phrase "IN THE RANGE", one of a set of arithmetic operator symbols ("=", ">", "<", ">=", or "<="), or the word "CHANGED". When the operator selects the phrase "IN THE RANGE", the logic analyzer displays two boxes 79 and 81 separated by the word "THROUGH" and the operator can type data values into these boxes to indicate the range of register content values that the logic analyzer is to search for.

FIG. 10B illustrates a search format window 68 which tells the logic analyzer to search for and display the next bus cycle data line indicating an instruction which causes the content of address register to equal or exceed 000001. FIG. 10C illustrates a search format window 68 which tells the logic analyzer to search for and display the next bus cycle data line indicating an instruction which causes the content of any register to change.

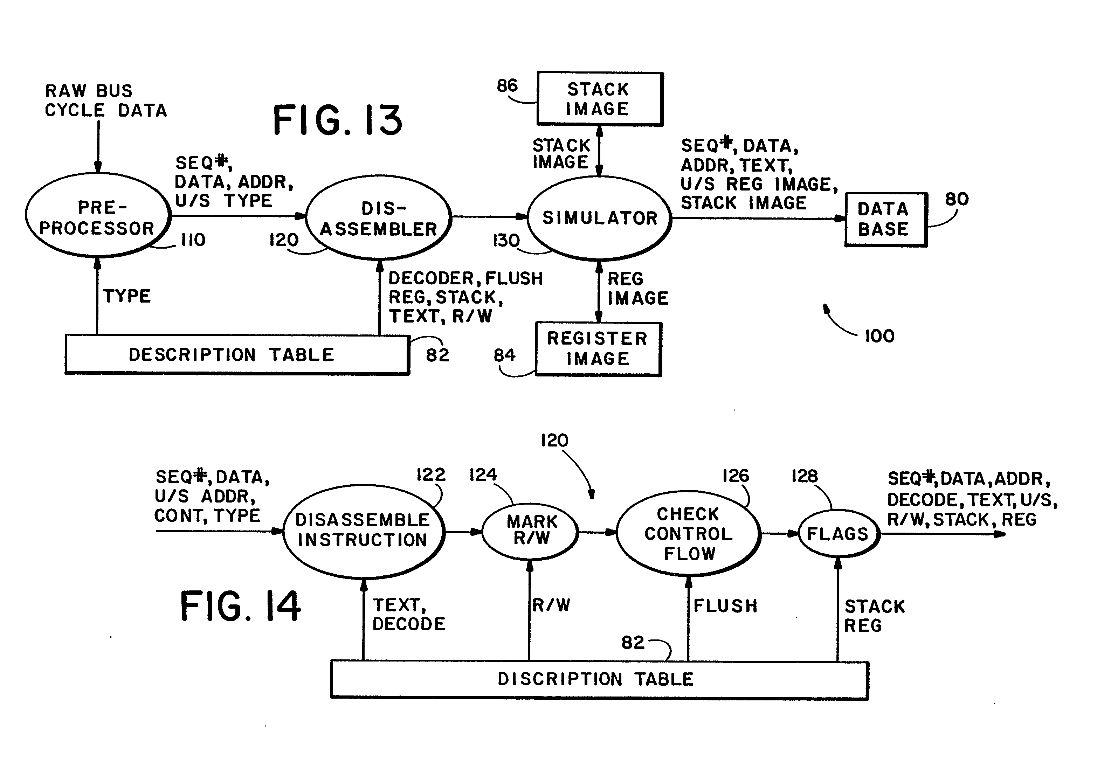

The logic analyzer of the present invention can also perform searches based on the changes to a stack. This type of search is performed when the logic analyzer is displaying a stack image, as illustrated in FIG. 6. Search format windows 68 for stack type searches asre illustrated in FIGS. 11A and 11B. The search format window of FIG. 11A tells the logic analyzer to search for a point during execution of the instructions wherein the microprocessor under test moved the words 1232 and F127 onto the stack (user or supervisor) being displayed. The logic analyzer is adapted to search for stack data in sequences of up to four words when these words are typed into boxes 76. The search format window 68 in FIG. 11B tells the logic analyzer to search for a point during execution of the instruction when the stack pointer value is less than 000006FE. A "less than" symbol "<" in a box 77 in FIG. 11B can be toggled to display a symbol ">", "=", ">=" or "<=" to change the decision basis for the stack pointer search.

Thus the logic analyzer of the present invention displays the decoded bus cycle data and the deduced register and stack contents, and an operator can specify what bus cycle data is to be displayed or suppressed, and can also specify various types of searches to be performed by the logic analyzer on the bus cycle data.

FIGS. 12-18 are a set of signal flow charts describing software for controlling the operation of the microprocessor 24 of the logic analyzer 10 of FIG. 1 when the microprocessor accesses and decodes the data in the acquisition memory 22, when it deduces the contents of the registers and stacks, and when it creates displays on screen 32. In the signal flow charts of FIGS. 12-18, software routines and blocks of software routines are represented by ellipses and data sources and destinations are represented by boxes.

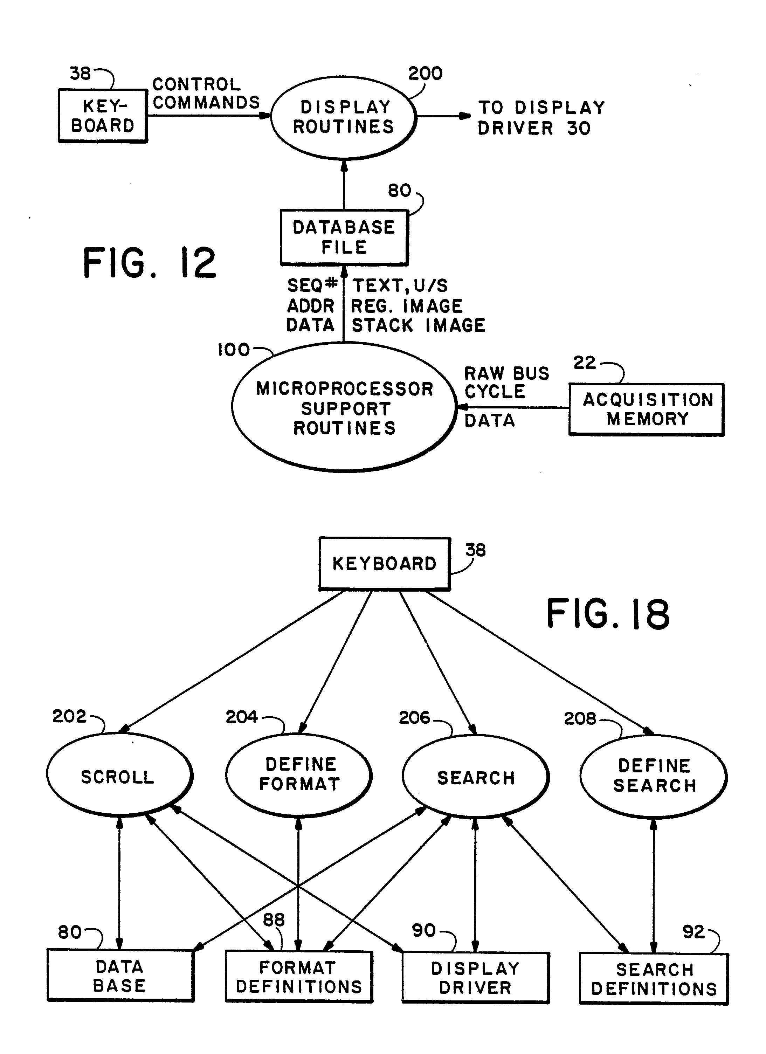

FIG. 12 is a high level view of the logic analyzer software which comprises two major blocks of routines, including microprocessor support routines 100 and display routines 200. The support routines 100 obtain the raw data associated with each bus cycle from the acquisition memory 22 and decode this data on a cycle-by-cycle basis to determine what information was carried on the bus and what changes the microprocessor under test made to the registers and stacks in response to this information. The support routines 100 produce a set of output parameters which describe the data on the bus during each bus cycle and which characterize the state of the registers and stacks immediately following each bus cycle. These parameters include the sequence number (SEQ#), the hexadecimal bus address line data (ADDR) and bus data line data (DATA), the mnemonic text (TEXT) indicating the instruction or bus cycle cycle type, the user or supervisor (U/S) mnemonic to be displayed, the contents of the internal registers (REG. IMAGE), and the contents of the stacks (STACK IMAGE). One set of such data is stored in a data base file 80 for each set of bus cycle data stored in acquisition memory 22. The display routines 200 access the display data in data base file 80 and display this data on the screen via signals transmitted to display driver 30 of FIG. 1. The display routines 200 format and manipulate the display according to control commands from the user via keyboard 38. FIGS. 12-17 describe the microprocessor support routines 100 in more detail, while FIG. 18 describes the display routines 200 in more detail.

Referring to the signal flow chart of FIG. 13, the microprocessor support routines 100 of FIG. 12 include a preprocessor routine 110, a disassembler routine 120, and a simulator routine 130. The preprocessor routine 110 reads the raw bus cycle data from the acquisition memory 22, one cycle at a time, and organizes the data into binary words indicating the contents of the data and address lines of the microprocessor under test during the bus cycle. The preprocessor routine 110 converts the binary data and address words into representative hexadecimal parameters (DATA, and ADDR) and also converts the acquisition memory address from which the bus cycle data was read into a decimal sequence number (SEQ#). The preprocessor routine 110 decodes the incoming control line data to determine the bus cycle type (i.e., instruction fetch, read, write, interrupt, etc.) and creates a parameter (TYPE) indicating the bus cycle type. It also decodes the control line data to determine whether the microprocessor was operating in a user or supervisory mode and assigns the appropriate mnemonic (U) or (S) to the mode indicating parameter (U/S). In order to determine the bus cycle type, the preprocessor routine 100 utilizes a "description table" 82, a data file stored on a disk in disk drive 28 and loaded into RAM 26 of FIG. 1. The description table file 82 comprises a set of data tables which characterize aspects of the microprocessor under test, for instance by relating control line data to cycle type, by relating data line data to the instruction type, and by relating instruction type to changes to the contents of registers and stacks caused by the instructions. As discussed hereinbelow, the description table file 82 is utilized for decoding purposes by many of the microprocessor support routines 100.

The SEQ#, DATA, ADDR, U/S and TYPE parameters generated by the preprocessor routine 110 are passed to a disassembler routine 120 of FIG. 12, which decodes the TYPE and DATA parameters to determine the nature of the TEXT parameter to be displayed in the bus cycle data line associated with the bus cycle. The disassembler routine 120 also utilizes the description table 82 to decode the incoming TYPE and DATA parameters. In response to the TYPE and DATA parameters, the description table sets the TEXT parameter to indicate the assembly language mnemonic for the instruction fetched or the bus cycle type indication (READ, WRITE, etc.). When the current bus cycle conveys an instruction, the description table 82 tells the disassembler routine 120 to set a REG flag, if the instruction affects the contents of a register, or to set a STACK flag, if the instruction affects a stack. The description table 82 also returns a parameter (DECODE) indicating how the instruction affects a register or stack. (The DECODE parameter subsequently controls the operation of the simula tor routines 130, discussed hereinbelow, which keep track of changes to the registers and stacks.) In addition, when the current bus cycle conveys an instruction requiring the microprocessor under test to transfer data on the bus using read or write type bus cycles, the description table 82 returns to the disassembler routine 120 another parameter (R/W) which indicates the number of read or write bus cycles to follow the current bus cycle.

The description table 82 also tells the disassembler 120 to set a flag (FLUSH) when the current bus cycle conveys a jump, branch, return or similar instruction of the type causing the microprocessor under test to flush the next fetched instruction. The disassembler routine 120 remembers the state of this flag and does not decode the incoming TYPE and DATA parameter for the next bus cycle but merely sets the TEXT parameter to "-(FLUSHED CYCLE)" and resets the FLUSH, REG and STACK flags.

The SEQ#, DATA, ADDR, TEXT, U/S, DECODE and R/W parameters, along with the REG and STACK flags produced by the disassembler routine 120 are passed to a simulator routine 130 which simulates the operation of the microprocessor under text with respect to the way in which the microprocessor changes the contents of its internal registers and of the user and supervisor stacks in response to each instruction. The simulator routine 130 looks at the incoming REG and STACK flags to determine if the incoming data represents a bus cycle which conveyed an instruction affecting the contents of a register or a stack. If so, the simulator outine looks at the R/W parameter to determine how many subsequent bus cycles were required to execute the instruction and then waits until it receives the incoming data for each of the subsequent read or write bus cycles. If a register was affected by the instruction, simulator routine 130 updates a "register image" file 84 containing the value of data stored in each internal register of the microprocessor under test following the bus cycle associated with the bus cycle data currently being processed by the simulator routine. If the instruction affected a stack, the simulator routine 130 updates a "stack image" file 86 containing data indicating the contents of the user and supervisor stacks and the current stack pointer positions. The simulator routine utilizes the incoming DECODE parameter and the description tables 82 to determine how the register and stack images are to be modified. After the simulator routine 130 has updated the stack or register image files (if necessary), the simulator routine 130 stores the current register image data (REG IMAGE) and stack image data (STACK IMAGE) in the data base file 80 along with the SEQ#, DATA, ADDR, TEXT, and U/S parameters.

Referring to the signal flow diagram of FIG. 14, the disassembler routine 120 of FIG. 13 is subdivided into a set of four table lookup subroutines. A "disassemble instruction" subroutine 122 applies the TYPE and DATA parameters to the description table 82 to obtain the appropriate TEXT and DECODE parameter values and a "mark R/W" subroutine 124 applies the TEXT parameter to the description table to obtain the R/W parameter value. A "check control flow" subroutine 126 uses the description table 82 to determine whether an instruction indicated by the TEXT parameter requires the next cycle to be flushed. Finally, a "flags" subroutine 128 applies the TEXT parameter to the description table 82 to determine whether or not to set the STACK or REG flags.

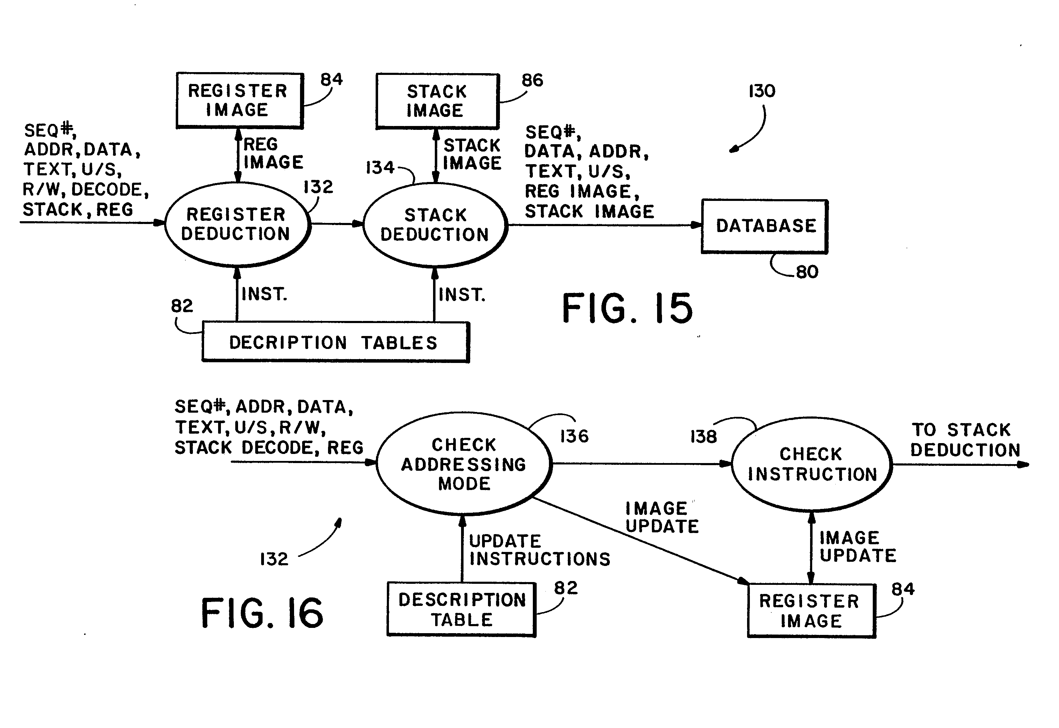

A signal flow diagram of FIG. 15 further details the simulator routine 130 of FIG. 13d which includes a "register deduction" subroutine 132 and a "stack deduction" subroutine 134. The register deduction subroutine 132 maintains the register image file 84 while the stack deduction subroutine 134 maintains the stack image file 86. Both deduction subroutines access description table file 82 to obtain instructions for updating the image files. The register deduction subroutine 132, flow charted in more detail in FIG. 16, includes a "check addressing mode" subroutine 136 which applies the TEXT parameter to the description table 82 to determine how the "addressing mode" of the current instruction affected the register. Many microprocessors, including the Motorola MC68000, permit "preincrement" and "postdecrement" register addressing modes wherein an instruction which causes the microprocessor to read the contents of an address register also causes the microprocessor to increment the contents of the register before reading the data, or the decrement the contents of the register after reading the data. These types of addressing modes are often utilized to increment or decrement the stack pointer in the stack register when data is pushed onto or pulled off of a stack. If the instruction indicates one of these addressing modes, the description table 82 returns register image update instructions to subroutine 136 and the subroutine updates the register image accordingly. The bus cycle data then passes from the check addressing mode subroutine 136 to a "check instruction subroutine" 138 which checks the REG flag to determine if the bus cycle data conveys an instruction directly affecting the contents of a register and if so, the subroutine 138 updates the register image file 84 according to data conveyed in the DECODE parameter.

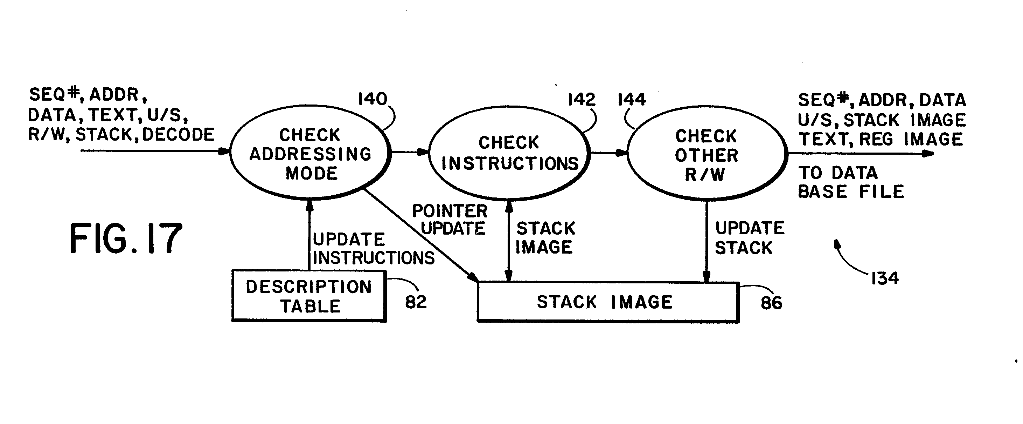

The stack deduction subroutine 134 of FIG. 15, signal flow charted in more detail in FIG. 17, also includes a "check addressing mode" subroutine 140 which utilizes the description table 82 to determine if an instruction addressing mode modifies a stack pointer address in a register. If so, the description table provides the check addressing mode subroutine 140 with instructions for updating pointer information stored in the stack image file 86. Next a "check instructions" subroutine 142 updates the data contents of the stack image file 86 to reflect any changes to the contents of a stack according to instructions provided by the incoming DECODE parameter. The stack pointer registers are usually modified by instructions utilizing preincrement or postdecrement addressing modes but occasionally an instruction may directly write data into a stack pointer register, though this is usually a result of a programming error. Accordingly a "check other instructions" subroutine 144 utilizes the description table 82 to check the TEXT parameter to determine if an instruction directly modifies the contents of the stack pointer register and if so, subroutine 144 updates the stack image file 86 to record the change to the stack pointer.

Referring again to FIG. 12, it is seen that the microprocessor support routines 100 use a series of table lookup routines to decode the incoming raw bus cycle data and to deduce the contents of the registers and stacks accessed by the microprocessor under test to determine after each bus cycle. The output parameters of the microprocessor support routines are stored in the database file 80 to provide the bus cycle, stack image and register image data utilized by the display routines 200.

The display routines 200 of FIG. 12, charted in more detail in FIG. 18, include a "scroll" routine 202, a "define format" routine 204, a "search" routine 206 and a "define search" routine 208. The define format routine 204 utilizes the display driver 90 to produce format command windows as illustrated in FIG. 8 which enable an operator using keyboard 38 to input data defining the type of bus cycle data to be displayed for various ranges of bus cycle sequence numbers. The define format routine 204 stores the format definition data in a format definitions file 88.

The scroll routine 202 scrolls the display of the bus cycle data lines and moves the position of the highlighting cursor 50 in response to keyboard 38 input from the operator. Each time the operator uses a key on keyboard 38 to command the logic analyzer to scroll the display up by one line of bus cycle data, the scroll routine 202 checks the format definitions file 88 to determine what types of bus cycle data are to be displayed and what kinds are to be suppressed. The scroll routine 202 then searches the data base file for the next line of bus cycle date which satisfies the format definitions stored in file 88 and transmits commands to display driver 90 to add the new bus cycle data as the last line on the display and to scroll up the other lines. The scroll routine also keeps track of the current position of the highlighting cursor and when the cursor is moved to a new bus cycle data line, the scroll routine obtains the appropriate stack or register image data from the data base file 88 and updates the stack or register image display via the display driver 90.

The define search routine 208 controls via display driver 90 the display of the search format window 68 as illustrated, for example, in FIG. 11A. When the user changes the contents of boxes in the search format window using keyboard 38 commands, the define search routine 208 stores the search routine definitions provided by the operator in a search definitions file 92 according to the search name indicated by the operator. When the operator commands the logic analyzer to perform a search via keyboard 38, the search routine 206 obtains the specifications for the search from the search definitions file 92 and then searches through the data base file 80 to find the next bus cycle data which satisfies the search specifications for the particular search requested by the operator. The search routine 206 also checks the current display format specification in the format definitions file 88, and as it searches for the bus cycle data which satisfies the search specifications, the search routine acquires from the data base file 80 the bus cycle data for each bus cycle which satisfies the current display format specification. This data is added to the bottom of the displayed bus cycle list via commands to display driver 90, causing the display driver to scroll the display upwards until the line which satisfies the search specification is found and displayed. The search routine 206 also updates the register or stack image, if displayed, as the scrolled bus cycle data scroll under the highlighting cursor.

The logic analyzer of the present invention as described herein is thus adapted to acquire and decode data appearing on a bus connected to terminals of a microprocessor executing a sequence of microcode instructions. The logic analyzer not only displays representations of the decoded data carried on the bus, but also displays information indicating the bus cycle type and identifies the instructions carried to the microprocessor on the bus. Further, the logic analyzer deduces and displays the contents of various internal registers in the microprocessor and of stacks maintained by the microprocessor and automatically locates bus cycles during which the microprocessor was instructed to perform operator specified changes to the registers and stacks. These instruction decoding, register and stack deducing and search features of the logic analyzer are useful in assisting a skilled programmer to rapidly locate programming errors in the instructions executed by the microprocessor under test.

While a preferred embodiment of the present invention has been shown and described, it will be apparent to those skilled in the art that many changes and modifications may be made without departing from the invention in its broader aspects. The appended claims are therefore intended to cover all such changes and modifications as fall within the true spirit and scope of the invention.

**Claims**

1. A method for monitoring the content of an internal register within a computer processor executing a sequence of instructions, the method comprising the steps of:
storing in a memory a data base containing entries corresponding to computer processor instructions of the type which cause a computer processor to store data in an internal register, each entry describing a procedure for determining the value of data stored in said internal register following computer processor execution of the instruction corresponding to said entry;
performing procedures described by said data base entries corresponding to instructions of said sequence of instructions to determine a sequence of data values the computer processor stored in said internal register in the course of executing said sequence of instructions; and
displaying said determined sequence of data values.

2. A method for monitoring the content of an internal register within a computer processor executing a sequence of instructions conveyed to the computer processor by signals applied to external terminals of the computer processor, at least one of the instructions causing the computer processor to store data in the internal register, the method comprising the steps of:
storing in a data memory a data base containing entries corresponding to computer processor instructions of the type which cause a computer processor to store data in an internal register, each entry describing a procedure for determining the value of data stored in said internal register following computer processor execution of the instruction corresponding to said entry;
monitoring signals appearing at external terminals of the computer processor;
decoding the monitored signals to ascertain the sequence of instructions conveyed to the computer processor;
performing procedures described by said data base entries corresponding to at least one instruction of said ascertained sequence of instructions to determine the value of the data stored in said internal register; and
displaying said determined data value.

3. A method for monitoring the content of an internal register within a computer processor executing a sequence of instructions conveyed to the computer processor by signals applied to external terminals of the computer processor, at least one of the instructions causing the computer processor to store data in the register, the method comprising the steps of:
monitoring signals appearing at external terminals of the computer processor;
decoding the monitored signals to ascertain the sequence of instructions conveyed to the computer processor; and
deducing the content of the internal register from the ascertained sequence of instructions.

4. A method for monitoring the content of an internal register within a computer processor executing a sequence of instructions conveyed to the computer processor by signals applied to external terminals of the computer processor, at least one of the instructions causing the computer processor to store data in the register, the method comprising the steps of:
storing in a data memory a data base containing entries corresponding to computer processor instructions of the type which cause said computer processor to store data in a register, each entry describing a procedure for determining the value of data stored in said register following computer processor execution of the instruction corresponding to said entry;
storing in an acquisition memory the states of signals appearing at external terminals of the computer processor;
decoding the stored signal states to ascertain the instructions conveyed to the computer processor;

and

performing procedures described by said data base entries corresponding to at least one instruction of said ascertained sequence of instructions to determine the value of the data stored in said register.

5. The method according to claim 4 further comprising the steps of:

displaying representations of operator selected types of ascertained instructions, said representations being displayed in the order that the computer processor executes the instructions corresponding to the displayed instruction representations; and

displaying a representation of the content of said register as said content existed immediately following computer processor execution of an instruction corresponding to an operator selected one of the displayed instruction representations.

6. The method according to claim 4 further comprising the step of displaying representations of ascertained instructions and a representation of the deduced content of said register as said content existed following computer processor execution of an instruction corresponding to one of the displayed instruction representations.

7. The method according to claim 6 wherein the step of displaying representations of ascertained instructions and a representation of the deduced content of said register as said content existed following computer processor execution of an instruction corresponding to one of the displayed instruction representations comprises the steps of:

obtaining from an operator a specification of a particular register content;

displaying a representation of a particular one of said sequence of instructions which caused the computer processor to modify said register content to match the operator specified content; and

displaying a representation of the content of sasid register as said content existed immediately following computer processor execution of said particular instruction.

8. An apparatus for monitoring the content of an internal register within a computer processor following computer processor execution of a ssequence of instructions conveyed to the computer processor by signals applied to external terminals of the computer processor, the apparatus comprising:

a data memory storing a data base containing entries corresponding to computer processor instructions of the type which cause said computer processor to store data in said internal register, each entry describing a procedure for determining the value of data stored in said internal register following computer processor execution of the instruction corresponding to said entry;

means for monitoring signals appearing on external terminals of the computer processor;

means for performing procedures described by said data base entries corresponding to at least one instruction of said ascertained sequence of instructions to determine the value of the data stored in said internal register; and

means for displaying said determined data value.

9. An apparatus for monitoring the content of an internal register within a computer processor following its execution of a sequence of instructions conveyed to the computer processor by signals applied to external terminals of the computer processor, the apparatus comprising:

probe means for accessing signals appearing at the external terminals of the computer processor;

an acquisition memory for storing data representing the states of signals accessed by the probe means; and

means for decoding the data stored in the acquisition memory to ascertain the sequence of instructions conveyed to the computer processor and for deducing changes to the content of the internal register resulting from the ascertained sequence of instructions.

10. The apparatus according to claim 9 further comprising means for displaying representations of ascertained instructions and a representation of the deduced content of said internal register as said content existed following computer processor execution of an instruction corresponding to one of the displayed instruction representations.

11. The apparatus according to claim 9 further comprising means for displaying representations of ascertained instructions of types specified by an operator, said representations being displayed in the order that the computer processor executes the instructions corresponding to the instruction representations, and for displaying a representation of the content of the internal register as said content existed immediately following computer processor execution of an instruction corresponding to an operator selected one of the displayed instruction representations.

12. A method for monitoring the content of a data stack maintained by a computer processor executing of a sequence of instructions conveyed to the computer processor by signals applied to external terminals of the computer processor, the method comprising the steps of:

storing in a data memory a data base containing entries corresponding to computer processor instructions of the type which cause said computer processor to alter the content of a data stack, each entry describing a procedure for determining the content of said data stack following computer processor execution of the instruction corresponding to said entry;

monitoring signals appearing on external terminals of the computer processor;

decoding the monitored signals to ascertain the sequence of instructions conveyed to the computer processor; and

performing procedures described by said data base entries corresponding to instructions of said sequence of instructions to determine the content of said data stack.

13. A method for monitoring the content of a data stack maintained in a random access memory by a computer processor executing a sequence of instructions conveyed to the computer processor by signals applied to external terminals of the computer processor, the method comprising the steps of:

storing in an acquisition memory data indicating the states of signals appearing on external terminals of the computer processor;

decoding the stored data to ascertain the sequence of instructions conveyed to the computer processor; and

deducing the content of the data stack from the ascertained sequence of instructions.

14. A method according to claim 13 further comprising the step of displaying representations of ascertained instructions and a representation of the deduced content of said data stack as said content existed following computer processor execution of an instruction corresponding to one of the displayed instruction representations.

15. An apparatus for monitoring the content of a data stack maintained by a computer processor executing a sequence of instructions conveyed to the computer processor by signals applied to external terminals of the computer processor, the apparatus comprising:

a data memory storing a data base containing entries corresponding to computer processor instructions of the type which cause said computer processor to alter the content of a data stack, each entry describing a procedure for determining the content of said data stack following computer processor execution of the instruction corresponding to said entry;

means for monitoring signals appearing on external terminals of the computer processor; and

means for decoding the monitored signals to ascertain the sequence of instructions conveyed to the computer processor and for performing procedures described by said data base entries corresponding to instructions to determine the content of said data stack.

16. An apparatus for monitoring the content of a data stack maintained in a random access memory by a computer processor executing a sequence of instructions conveyed to the computer processor by signals applied to external terminals of the computer processor, the apparatus comprising:

probe means for accessing signals appearing on the external terminals of the computer processor;

an acquisition memory for storing data representing the states of signals accessed by the probe means; and

means for decoding the data stored in the acquisition memory to ascertain the sequence of instructions conveyed to the computer processor and for deducing the content of the data stack from the ascertained sequence of instructions.

17. The apparatus according to claim 16 further comprising means for displaying representations of ascertained instructions and a representation of the deduced content of said data stack as said content existed following computer processor execution of an instruction corresponding to one of the displayed instruction representations.

| | A0 |
| --- | --- |
| | A1 |
| | A2 |
| | A3 |
| | A4 |
| | A5 |
| | A6 |
| USER STACK POINTER | A7 |
| SUPERVISOR STACK POINTER | |

| | D0 |
| --- | --- |
| | D1 |
| | D2 |
| | D3 |
| | D4 |
| | D5 |
| | D6 |
| | D7 |

# FIG. I (PRIOR ART)

14 — DATA RAM

15 — INSTR. MEMORY

12 — μP UNDER TEST

16

10

18

20 — DAS

22 — ACO MEMORY

38 — KEY-BOARD

26 — RAM

36

24 — μP

28 — DISK DRIVE

30 — DISPLAY DRIVER

32 — SCREEN

# FIG. 2

| SEQUENCE | ADDRESS | DATA | MNEMONIC | MODE |
|----------|---------|------|----------|------|
| 286 | 000006FE | OIF6 | (WRITE) | (S) |
| 287 | 000E0IF2 | 4E75 | RTS | (S) |
| 288 | 000E0IF4 | 6IFC | (FLUSHED CYCLE) | (S) |
| 289 | 000006FC | 000E | (READ) | (S) |
| 290 | 000006FE | OIF6 | (READ) | (S) |
| 291 | 000E0IF6 | 6100 | BSR  $+C | (U) |
| 292 | 000E0IF8 | 000A | | (S) |
| 293 | 000006FC | 000E | (WRITE) | (S) |
| 294 | 000006FE | OIFA | (WRITE) | (S) |
| 295 | 000E0202 | 4E75 | RTS | (U) |
| 296 | 000E0204 | 4204 | (FLUSHED CYCLE) | (S) |
| 297 | 000006FC | 000E | (READ) | (S) |
| 298 | 000006FE | OIFA | (READ) | (S) |
| 299 | 000E0IFA | 6IF6 | BSR   000E0IF2 | (S) |
| 300 | 000E0IFC | 6104 | (FLUSHED CYCLE) | (S) |
| 301 | 000006FC | 000E | (WRITE) | (S) |
| 302 | 000006FE | OIFC | (WRITE) | (S) |
| 303 | 000E0IF2 | 4E75 | RTS | (S) |
| 304 | 000E0IF4 | 6IFC | (FLUSHED CYCLE) | (S) |

40 SEQUENCE · 42 ADDRESS · 44 DATA · 46 MNEMONIC · 48 MODE · 50 · 52

| DATA ADDRESS | 0 | 1 | 2 | 3 | 4 | 5 | 6 | 7 |
|--------------|---|---|---|---|---|---|---|---|
| | E0000 | 400 | 400 | 400 | 400 | 400 | 400 | 400 |
| | 404 | 18 | 20 | 400 | 3F8 | 400 | 204 | |

FIG. 3

0 244 926

| SEQUENCE | ADDRESS | DATA | MNEMONIC | | MODE |
|---|---|---|---|---|---|
| I | 000E005E | 7804 | MOVEQ | #4,D4 | (U) |
| 2 | 000E0060 | 7A04 | MOVEQ | #4,D5 | (S) |
| 3 | 000E0062 | 247C | MOVEA.L | #00000004,A2 | (S) |
| 6 | 000E0068 | 0839 | BTST | #03,000E0000 | (S) |
| 10 | 000E0070 | 083B | BTST | #03,$-70(D4.L) | (S) |
| 14 | 0006E076 | 0B39 | BTST | D5,000E0000 | (S) |
| 18 | 000E007C | 073B | BTST | D3,$-7C(A2.L) | (S) |
| 21 | 000E0080 | 47B9 | CHK | 000E0000,D3 | (S) |
| 25 | 000E0086 | 4EF9 | JMP | 000E00E8 | (S) |
| 29 | 000E00E8 | 4EB9 | JSR | 000E008C | (U) |
| 32 | 000E008C | 207C | MOVEA.L | #00000400,A0 | (S) |
| 37 | 000E0092 | 227C | MOVEA.L | #00000400,A1 | (S) |
| 40 | 000E0098 | 247C | MOVEA.L | #00000400,A2 | (S) |
| 43 | 000E009E | 267C | MOVEA.L | #00000400,A3 | (S) |
| 46 | 000E00A4 | 287C | MOVEA.L | #00000400,A4 | (S) |
| 49 | 000E00AA | 2A7C | MOVEA.L | #00000400,A5 | (S) |
| 54 | 000E00B0 | 2C7C | MOVEA.L | #00000200,A6 | (S) |
| 55 | 000E00B6 | 203C | MOVE.L | #00000400,D0 | (S) |
| 58 | 000E00BC | 223C | MOVE.L | #00000400,DI | (S) |

FIG.4

| | 0 | 1 | 2 | 3 | 4 | 5 | 6 | 7 |
|---|---|---|---|---|---|---|---|---|
| DATA | ◇ | ◇ | ◇ | 4 | 4 | 4 | ◇ | ◇ |
| ADDRESS | ◇ | ◇ | 4 | ◇ | ◇ | ◇ | ◇ | |

0 244 926

| SEQUENCE | ADDRESS | DATA | MNEMONIC | | MODE |
|---|---|---|---|---|---|
| 1 | 000E005E | 7804 | MOVEQ | #4,D4 | (U) |
| 2 | 000E0060 | 7A04 | MOVEQ | #4,D5 | (S) |
| 3 | 000E0062 | 247C | MOVEA.L | #00000004,A2 | (S) |
| 6 | 000E0068 | 0839 | BTST | #03,000E0000 | (S) |
| 10 | 000E0070 | 083B | BTST | #03,$-70(D4.L) | (S) |
| 14 | 0006E076 | 0B39 | BTST | D5,000E0000 | (S) |
| 18 | 000E007C | 073B | BTST | D3,$-7C(A2.L) | (S) |
| 21 | 000E0080 | 47B9 | CHK | 000E0000,D3 | (S) |
| 25 | 000E0086 | 4EF9 | JMP | 000E00E8 | (S) |
| 29 | 000E00E8 | 4EB9 | JSR | 000E008C | (U) |
| 32 | 000E008C | 207C | MOVEA.L | #00000400,A0 | (S) |
| 37 | 000E0092 | 227C | MOVEA.L | #00000400,A1 | (S) |
| 40 | 000E0098 | 247C | MOVEA.L | #00000400,A2 | (S) |
| 43 | 000E009E | 267C | MOVEA.L | #00000400,A3 | (S) |
| 46 | 000E00A4 | 287C | MOVEA.L | #00000400,A4 | (S) |
| 49 | 000E00AA | 2A7C | MOVEA.L | #00000400,A5 | (S) |
| 54 | 000E00B0 | 2C7C | MOVEA.L | #00000200,A6 | (S) |
| 55 | 000E00B6 | 203C | MOVE.L | #00000400,D0 | (S) |
| 58 | 000E00BC | 223C | MOVE.L | #00000400,DI | (S) |

50

FIG. 5

52

| DATA ADDRESS | 0 | 1 | 2 | 3 | 4 | 5 | 6 | 7 |
|---|---|---|---|---|---|---|---|---|
| | ◇ | ◇ | ◇ | 4 | 4 | 4 | ◇ | ◇ |
| | 400 | ◇ | 4 | ◇ | ◇ | ◇ | ◇ | |

0 244 926

USER STACK

00000700  XXXX

000006FE  0IFA    54

000006FC  000E  ≪≪

| SEQUENCE | ADDRESS | DATA | MNEMONIC | OPERAND | MODE |
|----------|---------|------|----------|---------|------|
| 287 | 000E0IF2 | 4E75 | RTS | | (S) 50 |
| 291 | 000E0IF6 | 6100 | BSR | $+C | (U) |
| 295 | 000E0202 | 4E75 | RTS | | (U) |

# FIG. 6

USER STACK    54

00000700  XXXX  ≪≪

000006FE  0IFA

000006FC  000E

| SEQUENCE | ADDRESS | DATA | MNEMONIC | | MODE |
|----------|---------|------|----------|---|------|
| 291 | 000E0IF6 | 6100 | BSR | $+C | (U) 50 |
| 295 | 000E0202 | 4E75 | RTS | | (U) |
| 299 | 000E0IFA | 6IF6 | BSR | 000E0IF2 | (S) |

# FIG. 7

MODE  HARDWARE  REGISTER DISPLAY  ON

SHOW  EXECUTION  BETWEEN  000000  AND  0000FF

AND

SUPRESS  INTERRUPTS  BETWEEN  000000  AND  FFFFFF

AND

SHOW  TRACE  BETWEEN  000100  AND  FFFFFF

END

## FIG.8

NAME: SEARCH 7  SEARCH TYPE:  STACK

FIND WHEN THE  VALUES

XXXX
XXXX
1232
F127  ARE ON THE STACK

## FIG.11A

NAME: SEARCH 8  SEARCH TYPE:  STACK

FIND WHEN THE  STACK POINTER:

IS  <

000006FE

## FIG.11B

NAME: | SEARCH I |  SEARCH TYPE: | DISASSEMBLY |

69  FIND | WHEN THE RANGE | 71  70

| OO1234 |  THROUGH | OO1236 |

72  73

IS | ON THE DATA LINES | 74

**FIG. 9A**  68

---

NAME: | SEARCH 2 |  SEARCH TYPE: | DISASSEMBLY |

FIND | WHEN THE VALUE |

| FF4432 |

IS | ON THE ADDRESS LINES |

**FIG.9B**  68

---

NAME: | SEARCH 3 |  SEARCH TYPE: | DISASSEMBLY |

FIND | CALL TO |

75

| SUBROUTINE |

AT | 12457F2 |

**FIG.9C**  68

NAME: | SEARCH 4 |  SEARCH TYPE: | REGISTER |
                                              —76      68

FIND WHEN THE VALUE IN: | D2 | —77

78—
IS | IN THE RANGE |

        —79      81—
| 000000 | THROUGH | 123456 |

## FIG. 10A

NAME: | SEARCH 5 |  SEARCH TYPE: | REGISTER |

FIND WHEN THE VALUE IN: | A6 |                68

IS | >= |

| 000001 |

## FIG. 10B

NAME: | SEARCH 6 |  SEARCH TYPE: | REGISTER |

FIND WHEN THE VALUE IN: | ANY REG |          68

IS | CHANGED |

## FIG. 10C

FIG. 13

RAW BUS
CYCLE DATA

PRE-
PROCESSOR
110

SEQ#,
DATA, ADDR,
U/S TYPE

DIS-
ASSEMBLER
120

86  STACK
IMAGE

STACK
IMAGE

SIMULATOR
130

SEQ#, DATA,
ADDR, TEXT,
U/S REG IMAGE,
STACK IMAGE

DATA
BASE       80

TYPE

DECODER, FLUSH
REG, STACK,
TEXT, R/W

REG
IMAGE

DESCRIPTION TABLE       82

84   REGISTER
IMAGE

100

FIG. 14

SEQ#, DATA,
U/S ADDR,
CONT, TYPE

DISASSEMBLE
INSTRUCTION
122

MARK
R/W
124

120

CHECK
CONTROL
FLOW
126

FLAGS
128

SEQ#, DATA, ADDR,
DECODE, TEXT, U/S,
R/W, STACK, REG

TEXT,
DECODE

R/W

FLUSH

STACK
REG

82

DISCRIPTION TABLE

0 244 926

FIG. 15

FIG. 16

0 244 926

# FIG.17

SEQ#, ADDR,
DATA, TEXT, U/S,
R/W, STACK, DECODE

CHECK ADDRESSING MODE 140

CHECK INSTRUCTIONS 142 144

CHECK OTHER R/W

SEQ#, ADDR, DATA
U/S, STACK IMAGE
TEXT, REG IMAGE

TO DATA BASE FILE

UPDATE INSTRUCTIONS

POINTER UPDATE

STACK IMAGE

UPDATE STACK

DESCRIPTION TABLE 82

STACK IMAGE 86

134

0 244 926

FIG. 12

FIG. 18